# EUROPÄISCHE PATENTANMELDUNG

(11) **EP 1 179 847 A2**
(43) Veröffentlichungstag der Anmeldung: **13.02.2002**
(21) Anmeldenummer: 01114468.0
(22) Anmeldetag: 15.06.2001
(51) Int. Cl.: H01L 23/498, H01L 21/48

(54) **Trägermatrix für integrierte Halbleiter und Verfahren zu ihrer Herstellung**

(30) Priorität: 07.07.2000 DE 10034018
(71) Anmelder: Infineon Technologies AG, 81669 München (DE)
(72) Erfinder: Kahlisch, Knut, 01109 Dresden (DE); Mieth, Henning, 09387 Jahnsdorf (DE)
(74) Vertreter: Epping Hermann & Fischer

(57) **Zusammenfassung**

Trägermatrizen für Halbleiter werden häufig mit Abstandshaltern am Halbleiterchip angeordnet. Die Abstandshalter bestehen aus Silikon, welches in den Bereich der Bondleads fliessen und die sichere elektrische Verbindung der Bondleads mit dem Halbleiterchip verhindert. Zur Verhinderung dieses Flusses ist die Erfindung gerichtet auf eine Trägermatrix für integrierte Halbleiter mit einem Rahmen, Leiterbahnstrukturen und zumindest einem Bondlead (1) zur Verbindung der Leiterbahnstrukturen mit dem integrierten Halbleiter, und ist dadurch gekennzeichnet, dass das zumindest eine Bondlead (1) zwischen einem Bondbereich (3) und den Leiterbahnstrukturen (6) zumindest eine Barriere (7, 8) zur Verhinderung des Fliessens von flussfähigem Material auf den Bondbereich aufweist. Die Erfindung ist ebenfalls auf ein Verfahren zur Herstellung solcher Trägermatrizen gerichtet.

## Beschreibung

Die Erfindung betrifft eine Trägermatrix für integrierte Halbleiter mit einer Barriere an den Bondleads und ein Verfahren zur Herstellung einer solchen Trägermatrix.

Moderne Miniaturgehäuse für integrierte Halbleiter wie µBGA, FBGA etc. bestehen neben der eigentlichen Ummantelung und dem Siliziumchip aus einer Trägermatrix. Diese Trägermatrix dient der Stabilisierung und der elektrischen Verbindung der Kontaktflächen des Halbleiterchips mit den Außenkontakten des Gehäuses. Zu diesem Zweck weist die Trägermatrix einen Rahmen, beispielsweise eine geeignet ausgeformte Polyimidfolie von beispielsweise 50 µm Dicke auf sowie eine Leiterbahnstruktur, welche die Kontaktflächen miteinander verbindet. Zumeist wird der Halbleiterchip mit einer Seite der Trägermatrix verbunden, während auf der anderen Seite der Trägermatrix Kontakte zur Außenanbindung des Gehäuses auf einer Platine o.ä. angeordnet sind. Die Leiterbahnstruktur wird zumeist auf der Seite des Rahmens angeordnet, auf der auch der Halbleiterchip zu liegen kommt, während die Außenkontakte auf der anderen Seite liegen. Die Verbindung zwischen den Leiterbahnstrukturen und den Außenkontakten wird durch Löcher im Rahmen erreicht.

Die eigentliche Verbindung zwischen Leiterbahnstrukturen und dem Halbleiterchip erfolgt über sogenannte Bondleads, das heißt zungenförmige Bereiche an der Leiterbahnstruktur, die zum Halbleiterchip hin gebogen sind oder gebogen werden können, um mit den Kontaktflächen des Halbleiterchips in Kontakt zu treten. Die Bondleads werden dann an den Halbleiter gebondet, beispielsweise durch Schweißen, Mikroschweißverfahren oder Löten.

Bei einer üblichen Vorgehensweise werden die Bondleads in einem sogenannten Bondkanal konzentriert. Dieser Bondkanal ist eine Öffnung im Rahmen, welche von der Halbleiterchip-abgewandten Seite einen Zugang zu den Bondleads ermöglicht. Bei der Montage der Trägermatrix an den Halbleiterchip werden von der Halbleiterchip-abgewandten Seite der Trägermatrix mittels Bondstempeln die Bondleads zum Halbleiterchip hin gedrückt und dort gebondet.

Die Bondleads sind über einen sogenannten Anker mit dem Rest der Leiterbahnstrukturen verbunden. Auf der dem Anker gegenüberliegenden Seite befindet sich häufig ein Gegenanker, der über eine Sollbruchstelle mit dem eigentlichen Bondbereich des Bondleads verbunden ist. Beim Anpressen des Bondbereichs an die Kontaktstelle des Halbleiterchips reißt die Sollbruchstelle.

Zwischen Trägermatrix und Halbleiterchip werden häufig Abstandhalter eingesetzt, sogenannte Nubbins, welche die gewünschte Beabstandung zwischen den beiden Bauelementen bewirkt. Die Nubbins werden zumeist aus einem Silikonmaterial gefertigt und mittels Siebdruck auf die Trägermatrix aufgebracht. Zur Stabilisierung der Verbindung zwischen Trägermatrix und Halbleiterchip werden die Bondkanäle mit einem geeigneten Material ausgefüllt.

Bei der Herstellung der Nubbins mittels Siebdruck kann nicht ausgeschlossen werden, dass auf Grund ungenügender Abdichtung durch die Druckschablone das Silikonmaterial auf die elektrischen Verbindungsleitungen, insbesondere die Bondleads gelangt. Durch die spezifischen Eigenschaften des Silikonmaterials kriecht dieses bis zu den Flächen der Verbindungsleitungen, die in der weiteren Prozessfolge der Kontaktierung mit dem Halbleiterchip dienen. Da somit Silikonmaterial zwischen dem Bondbereich des Bondleads und der Kontaktfläche des Halbleiterchips vorhanden ist, kann eine elektrische Kontaktierung beim Bondvorgang nicht erreicht oder zumindest nicht sicher gewährleistet werden. Um solchen Problemen vorzubeugen, wurde bislang mittels diverser Präventivmaßnahmen, wie der zyklischen Reinigung der Schablonen beim Herstellungsprozess, beziehungsweise mittels unterschiedlicher Nachbehandlungsmethoden, wie einer Plasmareinigung oder einer chemischen Reinigung versucht, die Kontaminierung der Bondbereiche der Bondleads zu verhindern. Hiermit gelang es jedoch nicht, eine zuverlässige, von Silikonverunreinigung befreite Kontaktfläche in allen Fällen zu erreichen.

Es ist daher die Aufgabe der vorliegenden Erfindung, Maßnahmen bereitzustellen, welche ein Kriechen des Silikonmaterials in den Bondbereich zuverlässig verhindern können.

Diese Aufgabe wird gelöst durch die Bereitstellung einer Trägermatrix für integrierte Halbleiterchip gemäß dem unabhängigen Patentanspruch 1 sowie Verfahren zur Herstellung einer solchen Trägermatrix gemäß dem unabhängigen Patentanspruch 7.

Weitere vorteilhafte Aspekte, Ausgestaltungen und Details der vorliegenden Erfindung ergeben sich aus den abhängigen Patentansprüchen, der Beschreibung und der beigefügten Zeichnung.

Die Erfindung ist zunächst gerichtet auf eine Trägermatrix für integrierte Halbleiter mit einem Rahmen, Leiterbahnstrukturen und zumindest einem Bondlead zur Verbindung der Leiterbahnstrukturen mit dem integrierten Halbleiter, wobei die Trägermatrix dadurch gekennzeichnet ist, dass das zumindest eine Bondlead zwischen einem Bondbereich und den Leiterbahnstrukturen zumindest eine Barriere zur Verhinderung des Fliessens von flussfähigem Material aus dem Bondbereich aufweist.

Der erfinderische Grundgedanke liegt somit darin, statt aufwendige Reinigungsmaßnahmen durchzuführen, die Bondleads so umzugestalten, dass durch eine integrierte Barriere das Kriechen des für die Nubbins verwendeten Silikonmaterials in den Bondbereich verhindert wird.

Die Barriere stellt eine Trennlinie für das flussfähige Material zwischen den Leiterbahnen und dem Rahmen einerseits und dem Bondlead andererseits dar. Die Barriere ist günstigerweise so orientiert, dass sie quer zur möglichen Flussrichtung des Silikonmaterials über das gesamte Bondlead hinwegreicht. Das flussfähige Material ist vorzugsweise Silikon zur Ausbildung von Strukturen auf der Trägermatrix. Die Strukturen können hierbei Abstandhalter sein.

Grundsätzlich ist die Erfindung auch geeignet, andere flussfähige Materialien als die für Nubbins verwendeten Silikonmaterialien am Kriechen auf dem Bondbereich zu hindern, so dass die Erfindung auch für andere Techniken im Bereich der Herstellung von Trägermatrizen und Halbleitern verwendet werden kann.

Das zumindest eine Bondlead kann einen Anker zur Verbindung mit dem Rahmen aufweisen und die Barriere im Bereich des Ankers angeordnet sein.

Weiterhin kann das erfindungsgemäße Bondlead einen Gegenanker zur Verbindung seines dem Anker abgewandten Endes mit dem Rahmen aufweisen, wobei eine zweite Barriere im Bereich des Gegenankers angeordnet ist. Diese bevorzugte Ausführungsform kann Verwendung finden, wenn die Bondleads über einen Gegenanker und über eine Sollbruchstelle verfügen, die auf der dem Anker gegenüberliegenden Seite des Bondkanals mit dem Rahmen verbunden ist, wie oben beschrieben. In diesem Fall kann es nötig sein, beide möglichen Flussrichtungen des flussfähigen Materials durch Barrieren abzusichern.

Zur Ausgestaltung der Barriere stehen verschiedene Möglichkeiten zur Verfügung. So kann die Barriere eine Rille oder einen Wall aufweisen. Bei Verwendung einer Rille macht man sich den Kanteneffekt für Fluss und Adhäsion von flussfähigem Material zu Nutze, bei dem ein flussfähiges Material nicht in der Lage ist, um eine abwärts gerichtete Kante herum zu fließen. Auf diese Weise kann eine Rille eine wirksame Barriere für Flüssigkeiten darstellen. Auch die Verwendung eines Walls, das heißt vorspringenden Barriereelements, kann einen begrenzenden Effekt haben, der abhängig ist von den Adhäsionseigenschaften des flussfähigen Materials auf dem Bondlead.

Schließlich kann die Barriere einen Bereich mit einem Trennmittel aufweisen, welches das flussfähige Material abweist. Hier wird also das Adhäsionsvermögen des flussfähigen Materials auf dem Untergrund durch die Verwendung einer Beschichtung so verändert, dass es nicht in der Lage ist, über den beschichteten Bereich hinweg auf den zu schützenden Bondbereich zu kriechen.

Es ist möglich, verschiedene Arten der oben angesprochenen Barrieren miteinander zu kombinineren oder mehrere gleichartige Barrieren hintereinander auf dem Bondlead anzuordnen. Solche Maßnahmen können, wenn auch bei erhöhtem Aufwand, die Rückhaltewirkung der erfindungsgemäßen Barriere weiter verbessern.

Weiterhin ist die Erfindung auf ein Verfahren zur Herstellung einer Trägermatrix für integrierte Halbleiter mit einem Rahmen, Leiterbahnstrukturen und zumindest einem Bondlead zur Verbindung der Leiterbahnstrukturen mit dem integrierten Halbleiter gerichtet, das folgenden Schritt aufweist:
Einarbeiten einer Rille zwischen einem Bondbereich und
den Leiterbahnstrukturen zur Verhinderung des Fliessens von flussfähigem Material auf dem Bondbereich.

Hierbei kann das erfindungsgemäße Verfahren vorzugsweise photochemisch erfolgen und die folgenden Schritte aufweisen:
- Aufbringen einer Lackmaske; und
- Ätzen von Querrillen in den Anker des Bondleads.

Das Aufbringen der Lackmaske erfolgt z.B. in dem Fachmann geläufiger Weise durch Beschichten mit einem Phtotlack, Aufbelichten des gewünschten Musters und Entwickeln der Lackschicht.
Alternativ kann das Verfahren folgenden Schritt aufweisen:
Prägen von Querrillen in den Anker des Bondleads.

Um den Barriereeffekt zu verstärken, kann es bevorzugt sein, mehrere parallel verlaufende Barrieren hintereinander zu schalten.

Bei Herstellung von Rillen muß die Ätz- beziehungsweise Prägetiefe so bemessen sein, dass eine eventuell vorhandene Sollbruchstelle zwischen Bondbereich und Gegenanker bei der Montage der Bondleads weiterhin als solche fungiert; das heißt, dass ein Bruch beim Anpressen des Bondbereichs an den Halbleiterchip nicht an den Barrieren erfolgen soll.

Schließlich ist die Erfindung gerichtet auf ein Verfahren zur Herstellung einer Trägermatrix für integrierte Halbleiter mit einem Rahmen, Leiterbahnstrukturen und zumindest einem Bondlead zur Verbindung der Leiterbahnstrukturen mit dem integrierten Halbleiter, das folgenden Schritt aufweist:
Aufbringen zumindest eines Walls zwischen einem
Bondbereich des Bondleads und den Leiterbahnstrukturen zur Verhinderung des Fließens von flussfähigem Material auf den Bondbereich.

Das Aufbringen des Materials kann in üblichen Verfahren zur Herstellung von Halbleiter, wie beispielsweise Beschichtungsverfahren mit Plasmaabscheidung erreicht werden.

Die Herstellung der Barrieren kann bei der integrierten Herstellung der Leiterbahnstrukturen und Bondleads und vor ihrer Verbindung mit dem Rahmen der Trägermatrix erfolgen. Alternativ ist es auch möglich die Barrieren nach der Verbindung von Rahmen und Leiterbahnstruktur/Bondleadschicht anzubringen.

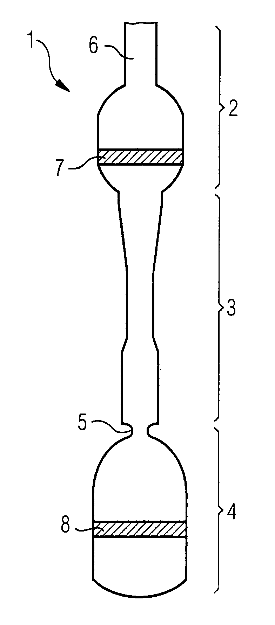

Im folgenden wird unter Bezugnahme auf Figur 1 ein Ausführungsbeispiel der vorliegenden Erfindung erläutert.

Figur 1 zeigt ein erfindungsgemäßes Bondlead 1, das in einer Trägermatrix verwendet wird, in Aufsicht auf die Barrieren. Dieses weist einen Ankerbereich 2, einen Bondbereich 3 und einen Gegenankerbereich 4 auf. Zwischen Gegenankerbereich 4 und Bondbereich 3 ist eine Sollbruchstelle 5 vorgesehen. Der Anker 1 ist an seinem dem Bondbereich abgewandten Ende mit einem Leiterzug 6 mit den Leiterbahnstrukturen der Trägermatrix verbunden. Eine erste Barriere in Form einer Rille 7 ist auf dem Anker 2 angeordnet. Eine weitere Barriere in Form einer Rille 8 ist auf dem Gegenanker angeordnet. Die erfindungsgemäße Barriere verhindert beziehungsweise verzögert signifikant ein Fließen von flussfähigem Material entlang der Bondleads, so dass eine Verschmutzung völlig ausgeschlossen werden kann, beziehungsweise bei nachfolgenden Reinigungsschritten eventuell noch vorhandene minimale Kontaminationsreste auf den Kontaktflächen, das heißt dem Bondbereich 3, zuverlässig beseitigt werden können.

## Patentansprüche

1. Trägermatrix für integrierte Halbleiter mit einem Rahmen, Leiterbahnstrukturen, zumindest einem Bondlead (1) zur Verbindung der Leiterbahnstrukturen mit dem integrierten Halbleiter und auf der Trägermatrix angeordneten flußfähigen Silikon-Strukturen zur Beabstandung von Trägermatrix und Halbleiter,
**dadurch gekennzeichnet, daß** das zumindest eine Bondlead zwischen einem Bondbereich (3) und den Leiterbahnstrukturen zumindest eine Rille (7,8) als Barriere zur Verhinderung des Fließens der Silikon-Strukturen auf den Bondbereich (3) aufweist.

2. Trägermatrix nach Anspruch 1,
**dadurch gekennzeichnet, dass** die Barriere (7, 8) eine Trennlinie für das flussfähige Material zwischen den Leiterbahnstrukturen und dem Rahmen einerseits, und dem Bondlead (1) andererseits darstellt.

3. Trägermatrix nach Anspruch 1 oder 2,
**dadurch gekennzeichnet, dass** die Strukturen Abstandshalter sind.

4. Trägermatrix nach einem der Ansprüche 1 bis 3,
**dadurch gekennzeichnet, dass** das zumindest eine Bondlead (1) einen Anker (2) zur Verbindung mit dem Rahmen aufweist und die Barriere (7) im Bereich des Ankers (2) angeordnet ist.

5. Trägermatrix nach Anspruch 4,
**dadurch gekennzeichnet, dass** der Bondlead (1) einen Gegenanker (4) zur Verbindung seines dem Anker (2) abgewandten Endes mit dem Rahmen aufweist, wobei eine zweite Barriere (8) im Bereich des Gegenankers (4) angeordnet ist.

6. Trägermatrix nach einem der Ansprüche 1 bis 5,
**dadurch gekennzeichnet, dass** die Barriere (7, 8) einen Bereich mit einem Trennmittel aufweist, welches das flussfähige Material abweist.

7. Verfahren zur Herstellung einer Trägermatrix für integrierte Halbleiter mit einem Rahmen, Leiterbahnstrukturen, zumindest einem Bondlead (1) zur Verbindung der Leiterbahnstrukturen mit dem integrierten Halbleiter und auf der Trägermatrix angeordneten flussfähigen Silikon-Strukturen zur Beabstandung von Trägermatrix und Halbleiter, mit folgendem Schritt:
Einarbeiten zumindest einer Rille zwischen einem
Bondbereich (3) und den Leiterbahnstrukturen zur
Verhinderung des Fließens der Silikon-Strukturen auf den
Bondbereich (3).

8. Verfahren nach Anspruch 7, **dadurch gekennzeichnet, dass** es folgende Schritte aufweist:
Aufbringen einer Lackmaske; und
Ätzen von Querrillen in den Anker des Bondleads (1).

9. Verfahren nach Anspruch 7,
**dadurch gekennzeichnet, dass** es folgenden Schritt aufweist:
Prägen von Querrillen in den Anker des Bondleads (1).
